# EUROPEAN PATENT SPECIFICATION

(11) **EP 4 366 474 B1**
(45) Date of publication and mention of the grant of the patent: **08.07.2026**
(21) Application number: 23819989.7
(22) Date of filing: 28.04.2023
(51) Int. Cl.: H05K 1/02, H05K 1/09, H05K 1/11

(54) **FLEXIBLE PRINTED CIRCUIT BOARD HAVING OVERCURRENT PROTECTION FUNCTION**
FLEXIBLE LEITERPLATTE MIT ÜBERSTROMSCHUTZFUNKTION
CARTE DE CIRCUIT IMPRIMÉ FLEXIBLE AYANT UNE FONCTION DE PROTECTION CONTRE LES SURINTENSITÉS

(30) Priority: 10.06.2022 KR 20220070608
(43) Date of publication of application: 08.05.2024
(73) Proprietor: LG ENERGY SOLUTION, LTD., Seoul 07335 (KR)
(72) Inventor: KIM, Young Joong, Daejeon 34122 (KR)
(74) Representative: Goddar, Heinz J.
(86) International application number: PCT/KR2023/005851
(87) International publication number: WO 2023/239053

(56) References cited:
- JP-A- 2000 340 078
- JP-A- 2000 340 078
- JP-A- 2002 025 420
- JP-A- 2002 025 420
- JP-A- 2002 178 289
- JP-A- 2002 178 289
- KR-A- 20220 022 590
- KR-A- 20220 040 300
- US-A- 5 478 665
- US-A1- 2015 282 304
- US-A1- 2015 282 304

## Description

### [Technical Field]

This application claims the benefit of priority to Korean Patent Application No. 2022-0070608 filed on June 10, 2022.

The present invention relates to the structure of a flexible printed circuit board having an overcurrent protection function including a shape memory material, and more particularly to the structure of a flexible printed circuit board capable of interrupting heat generated due to overcurrent generated by malfunction of a battery during charging/discharging of the battery, thereby preventing damage to a battery protection circuit or a major accident, such as fire outbreak.

### [Background Art]

With reduction in size and weight of electronic products in recent years, a flexible printed circuit board (FPCB) made of polyimide (PI), which is lightweight and flexible, has been widely used in a variety of electric and electronic products, such as a TV, an LCD, and a battery pack/module.

In particular, for the battery pack/module, a harness wire is used as a part configured to sensing voltage or temperature of each battery cell and to transmit the sensed voltage or temperature to a BMS. As the harness wire is replaced by a flexible printed circuit cable, however, electrical wiring in the battery module is greatly simplified, which is effective in reducing the weight of the battery module.

When abnormal overcurrent is generated during charging/discharging of a battery, it is necessary for each cable to have a fuse function in order to protect the battery. In particular, for the flexible printed circuit board (or cable), it is difficult to implement a fusing function in a limited space.

In order to solve this problem, Patent Document 0001 proposes an insulation film having a fuse pattern section configured to be cut when current higher than rated current flows. In this case, however, a circuit for protection from overcurrent is simply provided in a flexible printed circuit board, i.e. an overcurrent protection circuit is substantially designed and implemented in the flexible printed circuit board. As a result, a fuse pattern must be provided on each circuit from which overcurrent may be generated.

Patent Document 0002 is characterized in that, when heat is generated from a battery due to abnormality of the battery, an electrode lead including a shape memory alloy is deformed and is separated from an electrode tab, which, however, is difficult to apply to a flexible printed circuit board.

### (Prior Art Documents)

(Patent Document 0001) Korean Patent Application Publication No. 10-2022-0007346
(Patent Document 0002) Korean Patent Application Publication No. 10-2022-0022590

KR 2022-0040300 A describes a flexible printed circuit board for current overprotection, comprising first and second adhesive layers and first and second polyimide layers attached to a copper foil layer that includes a pattern fuse. US 2015 / 0 282 304 A1 describes shape memory alloys serving as stiffening layers to be attached to flexible printed circuit layers that relax into and retain a bent shape upon heating.

JP 2000-340078 A discloses a printed circuit board comprising a semiconductor relay. One side of this relay is directly connected to mounting lands of the printed circuit board. The other side of this relay is connected to mounting lands of the printed circuit board by means of a bimetallic plate that protects from overcurrent.

### [Disclosure]

### [Technical Problem]

The present invention has been made in view of the above problems, and it is an object of the present invention to provide a flexible printed circuit board configured such that a shape memory material that is deformed at a predetermined temperature or higher is provided in the flexible printed circuit board and the flexible printed circuit board is separated from a printed circuit board, to which the flexible printed circuit board is soldered, when heat is generated due to overcurrent, whereby fire outbreak is prevented or a battery protection circuit is safely physically separated from overcurrent.

### [Technical Solution]

In order to accomplish the above object, a system of a flexible printed circuit board for overcurrent protection and a printed circuit board is provided, the system including a soldering unit joined to one side of the printed circuit board by a solder according to the present invention includes a copper foil layer having a circuit pattern formed thereon, a first adhesive layer formed on the copper foil layer, a second adhesive layer formed under the copper foil layer, a first polyimide layer formed on the first adhesive layer, a second polyimide layer formed under the second adhesive layer, and a deformation layer formed between the first adhesive layer and the first polyimide layer or on the first polyimide layer, wherein the deformation layer includes a shape memory material configured to be deformed in a predetermined direction at a predetermined temperature or higher, wherein each of the copper foil layer and the printed circuit board comprises a plurality of lands for electrical connection; wherein the plurality of lands are electrically connected to each other by the solder, wherein, when a temperature increases to the predetermined temperature or higher as a result of an overcurrent being applied, the solder is melted and the land connected to the copper foil layer and the land of the printed circuit board are separated from each other by deformation of the deformation layer, whereby a current is interrupted.

Also, in the system according to the present invention, the deformation layer may be further formed between the second adhesive layer and the second polyimide layer.

Also, in the system according to the present invention, the predetermined direction may be a direction in which an end of the deformation layer is bent upwards from the printed circuit board.

Also, in the system according to the present invention, the predetermined direction may be a direction in which the deformation layer is bent upwards from the printed circuit board in a semilunar shape.

Also, in the system according to the present invention, the copper foil layer may be configured to have a multilayered structure disposed on opposite sides of an insulating layer with the insulation layer interposed therebetween.

Also, in the system according to the present invention, each of the copper foil layer and the printed circuit board includes a plurality of lands for electrical connection.

Also, in the system according to the present invention, the plurality of lands is electrically connected to each other by the solder.

Also, in the system according to the present invention, the solder may include a material having different melting points for the respective lands.

Also, in the system according to the present invention, when a temperature increases to the predetermined temperature or higher as a result of an overcurrent being applied, the solder is melted, and the land connected to the copper foil layer and the land of the printed circuit board are separated from each other by deformation of the deformation layer, whereby current is interrupted.

Also, in the system according to the present invention, the predetermined temperature may be a temperature equal to or higher than a melting point of the solder.

Also, in the system according to the present invention, the deformation layer may be limitedly located at only a specific area of the flexible printed circuit board including the soldering unit.

Also, in the system according to the present invention, the deformation layer may be limitedly located at only some of the plurality of lands.

Also, in the system according to the present invention, the deformation layer includes a shape memory material, the original shape of which is not restored after being deformed.

### [Advantageous Effects]

As is apparent from the above description, in a flexible printed circuit board including a shape memory material according to the present invention, a current flow path is narrowed when overcurrent is generated due to malfunction of a battery during charging and discharging of the battery, whereby heat is generated from a printed circuit board connected to the flexible printed circuit board by soldering, and when the temperature increases to a predetermined temperature or higher, a solder is melted, and at the same time the flexible printed circuit board is physically separated from the printed circuit board due to deformation of the shape memory material included in the flexible printed circuit board, whereby fire outbreak or explosion is prevented.

Also, in the flexible printed circuit board including the shape memory material according to the present invention, no additional part for protection from overcurrent is necessary, whereby performance is maintained without breakdown of a conventional protection circuit, and therefore stability of a battery pack/module is improved.

### [Description of Drawings]

FIG. 1 is a view showing the basic structure constituting a conventional flexible printed circuit board.
FIG. 2 is a view showing the structure of a single-layered flexible printed circuit board for overcurrent protection including a shape memory material according to a preferred embodiment of the present invention.
FIG. 3 is a view showing the structure of a single-layered flexible printed circuit board for overcurrent protection including a plurality of shape memory materials according to a preferred embodiment of the present invention.
FIG. 4 is a view showing the structure of a multilayered flexible printed circuit board for overcurrent protection including a shape memory material according to a preferred embodiment of the present invention.
FIG. 5 is a conceptual view showing that a printed circuit board according to a preferred embodiment of the present invention and the flexible printed circuit board are connected to each other via a solder.
FIG. 6 is a conceptual view showing the detailed structure in which the printed circuit board and the flexible printed circuit board according to the preferred embodiment of the present invention are soldered to each other.
FIG. 7 is a view showing the state in which a flexible printed circuit board according to a preferred embodiment of the present invention is deformed due to deformation of a shape memory material when overcurrent is applied thereto.
FIG. 8 is a view showing the state in which a flexible printed circuit board according to another preferred embodiment of the present invention is deformed due to deformation of the shape memory material when overcurrent is applied thereto.
FIG. 9 is a view showing the position of a deformation layer according to a preferred embodiment of the present invention.
FIG. 10 is a view showing a flexible printed circuit board having a deformation layer limitedly provided in a grouped soldering unit according to a further preferred embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, a material constituting a flexible printed circuit board according to the present invention and the structure in which the flexible printed circuit board is separated from a printed circuit board when abnormal overcurrent is applied thereto, whereby heat is generated therefrom, will be described with reference to the accompanying drawings.

First, the flexible printed circuit board according to the present invention may include an internal electronic circuit or may simply mean only a flexible printed circuit cable that replaces a harness wire; however, the flexible printed circuit board according to the present invention is not limited thereto.

In general, a flexible printed circuit board (FPCB) is constituted by a base film 20 having combined copper foil and polyimide and a coverlay having polyimide and a semi-cured adhesive applied to the completed base film.

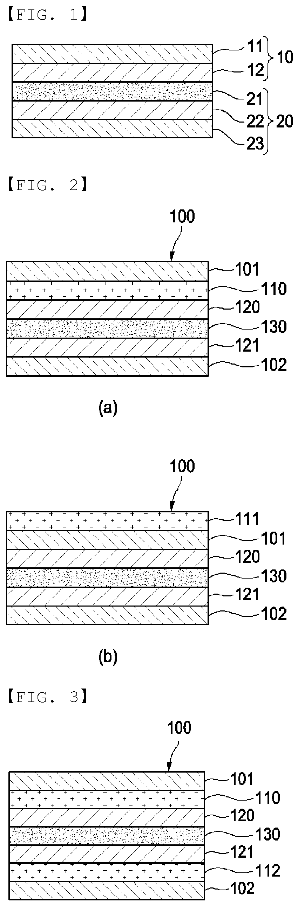

FIG. 1 is a view hierarchically showing the basic structure of a conventional flexible printed circuit board.

As shown in FIG. 1, a coverlay 10 is constituted by a polyimide layer 11 provided above and an adhesive layer 12 configured to allow the polyimide layer to be coupled to a copper foil layer 21 therethrough.

In addition, a base film 20 is constituted by a copper foil layer 21, a polyimide layer 23 for insulation provided under the copper foil layer 21, and an adhesive layer 22 configured to adhere the copper foil layer and the polyimide layer to each other. In addition, the copper foil layer 21 may be configured to have a multilayered structure, e.g. two or more layers.

In the conventional flexible printed circuit board, however, the structure or material capable for protecting a circuit constituting the flexible printed circuit board or other electric parts connected thereto when overcurrent is generated is not provided.

FIG. 2 is a view showing the structure of a single-layered flexible printed circuit board for overcurrent protection including a shape memory material according to a preferred embodiment of the present invention.

As shown in (a) of FIG. 2, the single-layered flexible printed circuit board 100 for overcurrent protection according to the present invention is constituted by one copper foil layer 130 constituting an electric circuit or a wire, a second polyimide layer 102 made of polyimide, the second polyimide layer being configured to isolate the flexible printed circuit board from the outside and to protect the flexible printed circuit board, and a second adhesive layer 121 configured to adhere the copper foil layer 130 and the second polyimide layer 102 to each other, in the same manner as the basic structure of the conventional base film 20.

In addition, the coverlay 10 includes a first adhesive layer 120 provided between a first polyimide layer 101 and the copper foil layer 130 and a deformation layer 110 provided between the first polyimide layer 101 and the first adhesive layer 120, the deformation layer being made of a shape memory material configured to be deformed at a predetermined temperature.

Here, the deformation layer 110 may be made of a shape memory allay, such as a nickel-titanium alloy (nitinol), a copper-zinc alloy, a gold-cadmium alloy, or an indium-thallium alloy, or a low cost epoxy or thermoplastic polyurethane-based shape memory polymer.

In addition, the deformation layer 110 is characterized in that the deformation layer is made of a unidirectional shape memory material, the shape (original shape) of which is not restored even when the temperature is lowered after being deformed at a predetermined temperature or higher. The reason for this is that the deformation layer is deformed as the result of overcurrent being applied thereto and, if the shape of the deformation layer is restored, additional overcurrent may be generated due to electric contact.

In the present invention, the shape memory material is not restricted; however, it is obvious to those skilled in the art that any known shape memory material may be easily adopted.

Meanwhile, although not shown in (a) of FIG. 2, an additional adhesive layer for fixed adhesion may be provided between the first polyimide layer 101 and the deformation layer 110.

(b) of FIG. 2 shows a single-layered flexible printed circuit board for overcurrent protection according to another preferred embodiment of the present invention. Unlike (a) of FIG. 2, this embodiment is characterized in that a separate deformation layer 111 is provided on the coverlay 10 of the conventional flexible printed circuit board of FIG. 1.

That is, when the deformation layer is provided in the flexible printed circuit board, there is a disadvantage in that the conventional flexible printed circuit board cannot be used. When the deformation layer 111 is provided on the first polyimide layer 101, however, there is an advantage in that the conventional flexible printed circuit board can be used through only an addition process.

Although not shown in (b) of FIG. 2, it is obvious that an adhesive layer configured to adhere the first polyimide layer 101 and the deformation layer 111 to each other is further provided, and a separate polyimide layer configured to protect the deformation layer 111 may be provided on the deformation layer 111.

In addition, although not shown in (b) of FIG. 2, the deformation layer 111 may also be provided under the base film 20, i.e. under the second polyimide layer 102.

FIG. 3 is a view showing the structure of a single-layered flexible printed circuit board for overcurrent protection including a plurality of shape memory materials according to a preferred embodiment of the present invention.

Referring to FIG. 3, a deformation layer 112 is further provided under the copper foil layer 130 in addition to the deformation layer 110 of (a) of FIG. 2. The deformation layer 112 is provided between the second polyimide layer 102 and the second adhesive layer such that the deformation layer can be more rapidly deformed when the temperature reaches a predetermined temperature.

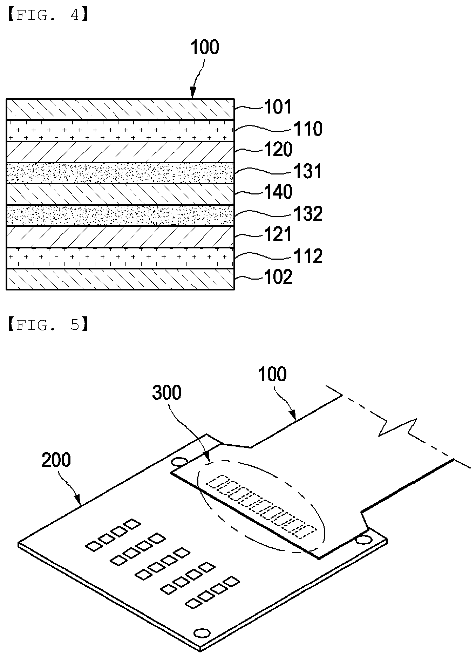

FIG. 4 is a view showing the structure of a multilayered flexible printed circuit board having two copper foil layers 131 and 132, each of which includes a shape memory material, according to a preferred embodiment of the present invention.

An insulation layer 140 including an adhesive component and made of an electrically insulating material may be provided between the two copper foil layers 131 and 132.

Although two copper foil layers are shown in the figure, which is merely one embodiment, it is obvious that multiple copper foil layers may be used.

In addition, although not shown in FIGS. 3 and 4, the deformation layers 110 and 112 may be provided on the first polyimide layer 101 and under the second polyimide layer 102, respectively.

FIG. 5 is a conceptual view showing that a printed circuit board 200 according to a preferred embodiment of the present invention and the flexible printed circuit board 100 are electrically connected to each other via a solder.

In general, the flexible printed circuit board 100 may include a plurality of lands. Each of the lands is a part of a conductor pattern for soldering electronic parts and corresponds to a contact point or a connection terminal for electrical connection with the copper foil layer.

As shown in FIG. 5, a soldering unit 300 indicated by a dotted line, which is configured to electrically join the flexible printed circuit board 100 and the printed circuit board 200 to each other and to fix the positions thereof, is constituted by a plurality of lands and a solder. The soldering unit may have various shapes and may be provided at various positions; but the shape and position of the soldering unit are not restricted.

Meanwhile, in a battery pack or a battery module, charging/discharging current flows to the printed circuit board 200 via the flexible printed circuit board 100. In a normal operation state, there is no problem. When abnormal overcurrent is generated, however, a protection circuit may malfunction. At this time, a current path may be narrowed, and a large amount of heat may be generated from the soldering unit 300, in which resistance is generated.

There is a possibility of ignition or explosion due to such generation of heat, and therefore it is necessary to physically separate the soldering unit 300 of the flexible printed circuit board 100 from the printed circuit board 200.

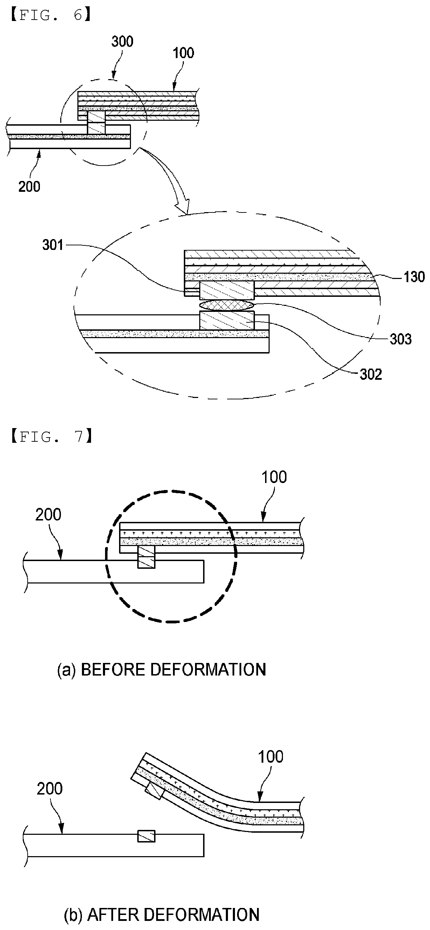

FIG. 6 is a side sectional view showing lands at which the printed circuit board 200 and the flexible printed circuit board 100 according to the preferred embodiment of the present invention are soldered to each other.

Referring to FIG. 6, a first land 301 connected to the copper foil layer 130 of the flexible printed circuit board 100 and a second land 302 provided at the printed circuit board 200 are joined to each other via a solder 303 so as to be electrically connected to each other.

Here, the solder 303, which is a nonferrous metal having a lower melting point than the first and second lands 301 and 302, may include a tin or lead component, and the respective lands may be made of different solders.

For example, a solder including a tin (Sn) component may have a melting point of 232°C, and a Sn-Zn-based unleaded solder for low temperature may have a melting point of about 190°C.

In the present invention, the kind and the melting point of the solder 303 that is adopted are not limited and may be variously selected. Each of the deformation layers 110, 111, and 112 made of the shape memory material is characterized in that the deformation layer is at least deformed at a melting point of the solder 303 or higher.

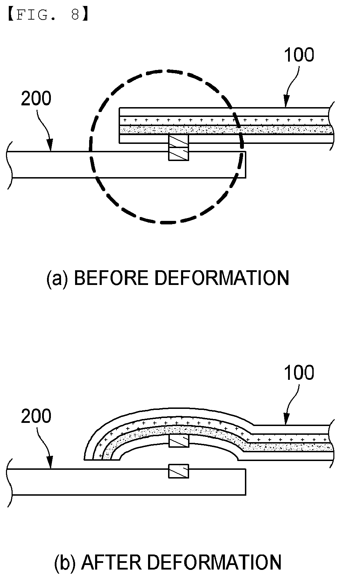

FIGS. 7 and 8 are views showing the state in which the flexible printed circuit board according to the preferred embodiment of the present invention is deformed due to deformation of the shape memory material when overcurrent is applied thereto.

Referring to (a) and (b) of FIG. 7, heat is generated from the soldering unit 300 as the result of overcurrent being applied thereto, the temperature of the heat reaches a predetermined temperature or higher, the solder 303 joined to the first land 301 and the second land 302 in the soldering unit is melted, and at the same time one side of the deformation layer 110 is bent upwards and the flexible printed circuit board 100 is physically separated upwards from the printed circuit board 200, whereby current is interrupted between the printed circuit board 200 and the flexible printed circuit board 100.

At this time, the deformation layer 110 does not return to the shape thereof before deformation even though the temperature of the deformation layer is lowered to low temperature.

The deformation layer 110 of FIG. 7 is desirable when the soldering unit 300 is formed at an end of the flexible printed circuit board 100. When the soldering unit 300 is located at a position far away from the end of the flexible printed circuit board 100, however, efficiency of the deformation layer is lowered.

The shape memory material of the deformation layer of FIG. 7 is bent in one direction. In contrast, the deformation layer 110 of FIG. 8 is deformed as the soldering unit 300 is bent upwards from the printed circuit board 200 in a semilunar shape, whereby physical separation between the printed circuit board 200 and the flexible printed circuit board 100 is achieved.

The deformation layer 110 of FIG. 8 is effectively applicable when the soldering unit 300 is located in the middle of the flexible printed circuit board 100.

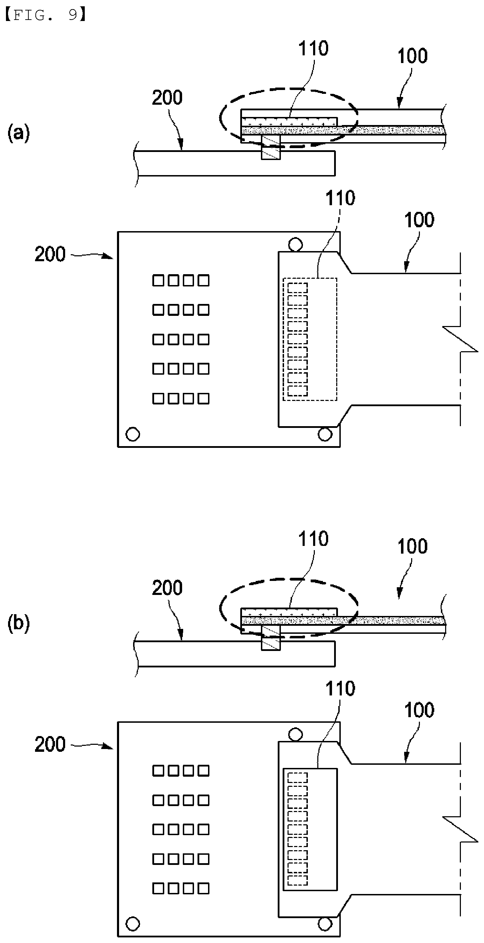

FIG. 9 is a view showing the position of a deformation layer according to a preferred embodiment of the present invention.

Each of the deformation layers 110, 111, and 112 according to various embodiments of the present invention is configured to separate the soldering unit 300 from the printed circuit board 200, and therefore the deformation layer may be provided over the entirety of the flexible printed circuit board 100. For cost reduction and process simplicity, however, the deformation layer may be located at the part of the flexible printed circuit board at which the soldering unit 300 is located so as to have a limited size.

Referring to (a) of FIG. 9, the deformation layer 110 may be limitedly provided at only an inner end of the flexible printed circuit board 100 at which the soldering unit 300 is located.

That is, the deformation layer 110 may be located in a partial limited area of the soldering unit 300 between the first polyimide layer 101 and the first adhesive layer 120.

Referring to (b) of FIG. 9, the deformation layer 110 may be limitedly provided at the uppermost part of the first polyimide layer 101 of the flexible printed circuit board 100 at which the soldering unit 300 is located.

Although not shown in FIG. 9, however, a separate adhesive layer may be further provided in order to adhere the deformation layer 110 and the first polyimide layer 101 to each other.

That is, in the flexible printed circuit board 100 of (b) of FIG. 2, a deformation layer having a size corresponding to the size of the soldering unit 300 may be separately adhered to the top of the coverlay 10, whereby the conventional flexible printed circuit board may be utilized without change, and the size of the deformation layer may be minimized, whereby cost reduction may be achieved.

In addition, although not shown in (a) of FIG. 9 and (b) of FIG. 9, the deformation layer may be limitedly provided in the middle of the soldering unit 300 even in the case of deformation of FIG. 8.

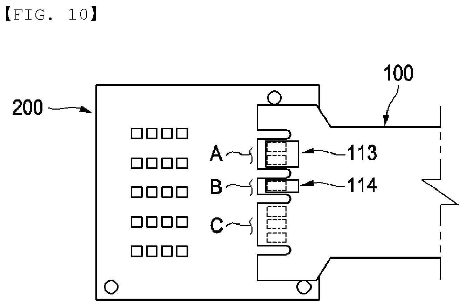

FIG. 10 is a view showing a flexible printed circuit board having a deformation layer limitedly provided in a grouped soldering unit according to a further preferred embodiment of the present invention.

FIG. 5 shows an embodiment in which a plurality of lands is soldered to one flexible printed circuit board in a line, whereas FIG. 10 shows a structure in which lands are grouped and soldered with respect to lines having a high possibility of overcurrent being generated, wherein deformation layers may be limitedly provided at only lines in which overcurrent is generated.

Referring to FIG. 10, a flexible printed circuit board configured such that deformation layers 113 and 114 are provided at only soldering units of line groups A and B in which overcurrent is generated and no deformation layer is provided at a soldering unit of a line group C in which no overcurrent is generated, i.e. a selective deformation layer is provided, is included as a further embodiment of the present invention.

In addition, referring to FIG. 10, the flexible printed circuit board may be formed so as to have a plurality of soldering units separated for line groups in the shape of a fork, and some of the plurality of soldering units may be selectively separated by the deformation layers 113 and 114.

Those skilled in the art to which the present invention pertains will appreciate that various applications and modifications are possible within the scope of the invention as defined by the appended claims.

### (Description of Reference Numerals)

10: Coverlay
20: Base film
11, 23: Polyimide layers
12, 22: Adhesive layers
21: Copper foil layer
100: Flexible printed circuit board
101: First polyimide layer
102: Second polyimide layer
110, 111, 112, 113, 114: Deformation layers
120: First adhesive layer
121: Second adhesive layer
130, 131, 132: Copper foil layers
140: Insulation layer 200: Printed circuit board
300: Soldering unit
301: First land
302: Second land
303: Solder

## Claims

1. A system of a flexible printed circuit board (100) for overcurrent protection and a printed circuit board (200), the system (100, 200) comprising
a soldering unit (300) joined to one side of the printed circuit board (200) by a solder (303), the flexible printed circuit board (100) further comprising:
a copper foil layer (130-132) having a circuit pattern formed thereon;
a first adhesive layer (120) formed on the copper foil layer (130-132);
a second adhesive layer (121) formed under the copper foil layer (130-132);
a first polyimide layer (101) formed on the first adhesive layer (120);
a second polyimide layer (102) formed under the second adhesive layer (121); and
a deformation layer (110-114) formed between the first adhesive layer (120) and the first polyimide layer (101) or on the first polyimide layer (101),
wherein the deformation layer (110-114) includes a shape memory material configured to be deformed in a predetermined direction at a predetermined temperature or higher,
wherein each of the copper foil layer (130-132) and the printed circuit board (200) comprises a plurality of lands (301, 302) for electrical connection;
wherein the plurality of lands (301, 302) are electrically connected to each other by the solder (303),
wherein, when a temperature increases to the predetermined temperature or higher as a result of an overcurrent being applied, the solder (303) is melted, and the land (301) connected to the copper foil layer (130-132) and the land (302) of the printed circuit board (200) are separated from each other by deformation of the deformation layer (110-114), whereby a current is interrupted.

2. The system (100, 200) according to claim **1,** wherein the deformation layer (110-114) is further formed between the second adhesive layer (121) and the second polyimide layer (102).

3. The system (100, 200) according to claim 1, wherein the copper foil layer (130-132) is configured to have a multilayered structure disposed on opposite sides of an insulating layer (140) with the insulation layer (140) interposed therebetween.

4. The system (100, 200) according to claim 1 or **2,** wherein the predetermined direction is a direction in which an end of the deformation layer (110-114) is bent upwards from the printed circuit board (200).

5. The system (100, 200) according to claim 1 or 2, wherein the predetermined direction is a direction in which the deformation layer (110-114) is bent upwards from the printed circuit board (200) in a semilunar shape.

6. The system (100, 200) according to claim **1,** wherein the predetermined temperature is a temperature equal to or higher than a melting point of the solder (303).

7. The system (100, 200) according to claim 1 or 2, wherein the deformation layer (110-114) is limitedly located at only a specific area of the flexible printed circuit board (100) comprising the soldering unit (300).

8. The system (100, 200) according to claim 1, wherein the deformation layer (110-114) is limitedly located at only some of the plurality of lands (301, 302).

9. The system (100, 200) according to claim 1 or **2,** wherein the deformation layer (110-114) includes a shape memory material, an original shape of which is not restored after being deformed.

## Patentansprüche

1. System mit einer flexiblen Leiterplatte (100) zum Überstromschutz und einer Leiterplatte (200), wobei das System (100, 200) Folgendes aufweist:
eine Löteinheit (300), die durch ein Lot (303) mit einer Seite der Leiterplatte (200) verbunden ist, wobei die flexible Leiterplatte (100) ferner Folgendes aufweist:
eine Kupferfolienschicht (130-132) mit einer darauf ausgebildeten Schaltungsstruktur;
eine erste Klebeschicht (120), die auf der Kupferfolienschicht (130-132) ausgebildet ist;
eine zweite Klebeschicht (121), die unter der Kupferfolienschicht (130-132) ausgebildet ist;
eine erste Polyimidschicht (101), die auf der ersten Klebeschicht (120) ausgebildet ist;
eine zweite Polyimidschicht (102), die unter der zweiten Klebeschicht (121) ausgebildet ist; und
eine Verformungsschicht (110-114), die zwischen der ersten Klebeschicht (120) und der ersten Polyimidschicht (101) oder auf der ersten Polyimidschicht (101) ausgebildet ist,
wobei die Verformungsschicht (110-114) ein Formgedächtnismaterial enthält, das konfiguriert ist, um bei einer vorbestimmten Temperatur oder höher in eine vorbestimmte Richtung verformt zu werden,
wobei jede der Kupferfolienschicht (130-132) und der Leiterplatte (200) mehrere Anschlussflächen (301, 302) zur elektrischen Verbindung aufweist;
wobei die mehreren Anschlussflächen (301, 302) durch das Lot (303) elektrisch miteinander verbunden sind,
wobei, wenn eine Temperatur infolge eines angelegten Überstroms auf die vorbestimmte Temperatur oder höher ansteigt, das Lot (303) geschmolzen wird und die Anschlussfläche (301), die mit der Kupferfolienschicht (130-132) verbunden ist, und die Anschlussfläche (302) der Leiterplatte (200) durch Verformung der Verformungsschicht (110-114) voneinander getrennt werden, wodurch ein Strom unterbrochen wird.

2. System (100, 200) nach Anspruch 1, wobei die Verformungsschicht (110-114) ferner zwischen der zweiten Klebeschicht (121) und der zweiten Polyimidschicht (102) ausgebildet ist.

3. System (100, 200) nach Anspruch 1, wobei die Kupferfolienschicht (130-132) konfiguriert ist, um eine mehrschichtige Struktur aufzuweisen, die auf gegenüberliegenden Seiten einer Isolierschicht (140) angeordnet ist, wobei die Isolierschicht (140) dazwischen angeordnet ist.

4. System (100, 200) nach Anspruch 1 oder 2, wobei die vorbestimmte Richtung eine Richtung ist, in der ein Ende der Verformungsschicht (110-114) von der Leiterplatte (200) nach oben gebogen ist.

5. System (100, 200) nach Anspruch 1 oder 2, wobei die vorbestimmte Richtung eine Richtung ist, in der die Verformungsschicht (110-114) von der Leiterplatte (200) in einer Halbmondform nach oben gebogen ist.

6. System (100, 200) nach Anspruch 1, wobei die vorbestimmte Temperatur eine Temperatur gleich oder höher als ein Schmelzpunkt des Lots (303) ist.

7. System (100, 200) nach Anspruch 1 oder 2, wobei die Verformungsschicht (110-114) nur an einem bestimmten Bereich der flexiblen Leiterplatte (100), die die Löteinheit (300) aufweist, begrenzt angeordnet ist.

8. System (100, 200) nach Anspruch 1, wobei die Verformungsschicht (110-114) nur an einigen der mehreren Anschlussflächen (301, 302) begrenzt angeordnet ist.

9. System (100, 200) nach Anspruch 1 oder 2, wobei die Verformungsschicht (110-114) ein Formgedächtnismaterial enthält, dessen ursprüngliche Form nach dem Verformen nicht wiederhergestellt wird.

## Revendications

1. Système avec une carte de circuit imprimé flexible (100) pour une protection contre les surintensités et une carte de circuit imprimé (200), le système 100, 200) comprenant
une installation de brasage (300) reliée à un côté de la carte de circuit imprimé (200) par une brasure (303), la carte de circuit imprimé flexible (100) comprenant en outre :
une couche de feuille de cuivre (130-132) sur laquelle a été formé un schéma de circuit ;
une première couche adhésive (120) formée sur la couche de feuille de cuivre (130-132) ;
une deuxième couche adhésive (121) formée sous la couche de feuille de cuivre (130-132) ;
une première couche de polyimide (101) formée sur la première couche adhésive (120) ;
une deuxième couche de polyimide (102) formée sous la deuxième couche adhésive (121) ; et
une couche de déformation (110-114) formée entre la première couche adhésive (120) et la première couche de polyimide (101) ou sur la première couche de polyimide (101),
la couche de déformation (110-114) comprenant un matériau à mémoire de forme configuré pour être déformé dans une direction prédéterminée à une température prédéterminée ou supérieure,
chacune de la couche de feuille de cuivre (130-132) et de la carte de circuit imprimé (200) comprenant une pluralité de lèvres (301, 302) pour une connexion électrique ;
la pluralité de lèvres (301, 302) étant reliées électriquement entre elles par la brasure (303),
et lorsqu'une température augmente jusqu'à la température prédéterminée, ou supérieure, à la suite de l'application d'une surintensité, la brasure (303) fond, et la lèvre (301) reliée à la couche de feuille de cuivre (130-132) et la lèvre (302) de la carte de circuit imprimé (200) sont séparées l'une de l'autre par la déformation de la couche de déformation (110-114), un courant étant ainsi interrompu.

2. Système (100, 200) selon la revendication 1, la couche de déformation (110-114) étant formée en outre entre la deuxième couche adhésive (121) et la deuxième couche de polyimide (102).

3. Système (100, 200) selon la revendication 1, la couche de feuille de cuivre (130-132) étant configurée de façon à posséder une structure multicouche disposée de côtés opposés d'une couche isolante (140), la couche isolante (140) étant intercalée entre elles.

4. Système (100, 200) selon la revendication 1 ou 2, la direction prédéterminée étant une direction dans laquelle un bout de la couche de déformation (110-114) est courbée vers le haut depuis la carte de circuit imprimé (200).

5. Système (100, 200) selon la revendication 1 ou 2, la direction prédéterminée étant une direction dans laquelle un bout de la couche de déformation (110-114) est courbée vers le haut depuis la carte de circuit imprimé (200) avec une forme semi-lunaire.

6. Système (100, 200) selon la revendication 1, la température prédéterminée étant égale ou supérieure à un point de fusion de la brasure (303).

7. Système (100, 200) selon la revendication 1 ou 2, la couche de déformation (110-114) étant placée de façon limitée seulement dans une zone spécifique de la carte de circuit imprimé flexible (100) composée de l'installation de brasage (300).

8. Système (100, 200) selon la revendication 1, la couche de déformation (110-114) étant placée de façon limitée dans certaines de la pluralité de lèvres (301, 302) seulement.

9. Système (100, 200) selon la revendication 1 ou 2, la couche de déformation (110-114) comprenant un matériau à mémoire de forme, dont la forme originale n'est pas rétablie après une déformation.
